# EUROPEAN PATENT APPLICATION

(11) **EP 3 693 491 A1**
(43) Date of publication of application: **12.08.2020**
(21) Application number: 20153813.9
(22) Date of filing: 27.01.2020
(51) Int. Cl.: C23C 14/04, H01L 51/00, H01L 27/32, H01L 21/027

(54) **MASK ASSEMBLY**

(30) Priority: 07.02.2019 KR 20190014491
(71) Applicant: Samsung Display Co., Ltd., Gyeonggi-Do (KR)
(72) Inventor: MOON, Jaesuk, Gyeonggi-do (KR); AHN, Junghyun, Gyeonggi-do (KR); KIM, Jongbum, Gyeonggi-do (KR); LEE, Seungjin, Gyeonggi-do (KR)
(74) Representative: Shearman, James Ward

(57) **Abstract**

A mask assembly includes a frame in which an opening is defined, a support portion on the frame and overlapping with the opening, and a mask on the support portion and covering at least a portion of the opening. The support portion may include a central layer, a first outer layer on a first surface of the central layer, and a second outer layer on a second surface of the central layer, the second surface being opposite to the first surface.

## Description

### BACKGROUND

### 1. Field

Aspects of embodiments of the present disclosure relate to a mask assembly and a method of manufacturing the same.

### 2. Description of Related Art

A display device may include a plurality of pixels. Each of the plurality of pixels may include an emission layer (or light emitting layer) disposed between opposite electrodes. The emission layer may be formed by at least one of various methods. For example, the emission layer may be formed by a deposition method using a mask. However, in a process of forming the emission layer using the mask, a shape of a support portion supporting the mask may be deformed, which causes a reduction in deposition reliability of the emission layer.

### SUMMARY

According to an aspect of embodiments of the present disclosure, a mask assembly capable of improving deposition reliability is provided. According to another aspect of embodiments of the present disclosure, a mask assembly capable of reducing deformation of a shape by temperature is provided.

According to another aspect of embodiments of the present disclosure, a method of manufacturing a mask assembly capable of improving deposition reliability is provided.

According to one or more embodiments of the inventive concepts, a mask assembly includes a frame in which an opening is defined, a support portion on the frame and overlapping with the opening, and a mask on the support portion and covering at least a portion of the opening. The support portion includes a central layer, a first outer layer on a first surface of the central layer, and a second outer layer on a second surface of the central layer, the second surface being opposite to the first surface.

In an embodiment, the first surface may be in direct contact with the first outer layer, and the second surface may be in direct contact with the second outer layer.

In an embodiment, the central layer may be metal-bonded to the first outer layer, and the central layer may be metal-bonded to the second outer layer.

In an embodiment, the central layer may include a different material from the first and second outer layers, and the first and second outer layers may include the same material.

In an embodiment, a thermal expansion coefficient of the central layer may be different from a thermal expansion coefficient of the first outer layer.

In an embodiment, a magnetic force of the central layer may be greater than a magnetic force of each of the first and second outer layers.

In an embodiment, the central layer may comprise Invar, and each of the first and second outer layers may comprise stainless steel.

In an embodiment, the support portion may be provided in plural, and the plural support portions may extend in a first direction and may be arranged in a second direction crossing the first direction.

In an embodiment, the support portion may be provided in plural, some of the plural support portions may extend in a first direction and may be arranged in a second direction crossing the first direction, and others of the plural support portions may extend in the second direction and may be arranged in the first direction.

In an embodiment, the mask may be provided in plural, the plural masks may extend in the first direction and may be arranged in the second direction, and a plurality of opening patterns may be defined in each of the masks.

In an embodiment, each of the frame and the mask may include Invar.

In an embodiment, the support portion may have a symmetrical structure with respect to the central layer.

In an embodiment, the first outer layer and the second outer layer may have the same thickness.

In an embodiment, the first outer layer and the second outer layer may have the same thermal expansion coefficient.

According to one or more embodiments of the inventive concepts, a mask assembly may include a frame in which an opening is defined, a support portion on the frame and overlapping with the opening, and a mask on the support portion and covering at least a portion of the opening. The support portion may include an odd number of base layers, and the base layers may have symmetrical thermal expansion coefficients with respect to a central layer of the base layers.

In an embodiment, the support portion may include a first outer layer of the base layers between the central layer and the frame, and a second outer layer of the base layers between the central layer and the mask. A magnetic force of each of the first and second outer layers may be less than a magnetic force of the central layer.

In an embodiment, the central layer may include Invar, and each of the first and second outer layers may include stainless steel.

According to one or more embodiments of the inventive concepts, a method of manufacturing a mask assembly may include providing a frame in which an opening is defined, forming a support portion to be arranged on the frame and overlapping with the opening, and providing a mask to be arranged on the support portion and covering at least a portion of the opening. The forming of the support portion may include preparing 2n+1 base members, where n is a natural number of 1 or more, and bonding the base members to each other by applying pressure to the base members.

In an embodiment, the forming of the support portion may further include scratching a surface, facing another of the base members, of surfaces of each of the base members.

In an embodiment, the bonding of the base members may be repeated a plurality of times.

### BRIEF DESCRIPTION OF THE DRAWINGS

The accompanying drawings are included to provide a further understanding of the inventive concepts, and are incorporated in and constitute a part of this specification. The drawings illustrate some example embodiments of the inventive concepts and, together with the description, serve to explain principles of the inventive concepts. In the drawings:
FIG. 1 is an exploded perspective view illustrating a mask assembly according to an embodiment of the inventive concepts;
FIG. 2 is a cross-sectional view illustrating a deposition apparatus according to an embodiment of the inventive concepts;
FIG. 3 is a cross-sectional view illustrating a substrate and a mask according to an embodiment of the inventive concepts;
FIG. 4 is a plan view illustrating a support portion according to an embodiment of the inventive concepts;
FIG. 5 is a cross-sectional view illustrating a support portion according to an embodiment of the inventive concepts;
FIG. 6 is a cross-sectional view illustrating a support portion according to an embodiment of the inventive concepts;
FIG. 7 is a cross-sectional view illustrating a support portion according to an embodiment of the inventive concepts;
FIG. 8A is an exploded perspective view illustrating a mask assembly according to an embodiment of the inventive concepts;
FIG. 8B is an exploded perspective view illustrating a mask assembly according to an embodiment of the inventive concepts;
FIG. 9 is a flowchart illustrating a method of manufacturing a mask assembly, according to an embodiment of the inventive concepts;
FIG. 10 is a flowchart illustrating a method of manufacturing a support portion, according to an embodiment of the inventive concepts; and
FIGS. 11A to 11D are cross-sectional views schematically illustrating some processes of a method of manufacturing a support portion, according to an embodiment of the inventive concepts.

### DETAILED DESCRIPTION

The inventive concepts will be described more fully herein with reference to the accompanying drawings, in which various example embodiments are shown. The inventive concepts may, however, be embodied in many different forms, and should not be construed as limited to the embodiments set forth herein. Rather, these embodiments are provided so that this disclosure will be thorough and complete, and will fully convey the scopes of the inventive concepts to those skilled in the art. Like reference numerals refer to like elements throughout.

It is to be understood that when an element, such as a layer, region, or substrate is referred to as being "on" another element, it may be directly on the other element or one or more intervening elements may be present. In contrast, the term "directly" means that there are no intervening elements. As used herein, the term "and/or" includes any and all combinations of one or more of the associated listed items.

The terminology used herein is for the purpose of describing particular embodiments and is not intended to be limiting. As used herein, the singular forms "a," "an," and "the" are intended to include the plural forms, including "at least one," unless the content clearly indicates otherwise. "Or" means "and/or." As used herein, the term "and/or" includes any and all combinations of one or more of the associated listed items. It is to be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Spatially relative terms, such as "beneath," "below," "lower," "above," "upper," and the like, may be used herein for ease of description to describe one element or feature's relationship to another element(s) or feature(s) as illustrated in the figures. It is to be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (e.g., rotated 90 degrees or at other orientations) and the spatially relative descriptors used herein interpreted accordingly.

It is to be understood that, although the terms "first," "second," etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings herein.

"About" or "approximately" as used herein are inclusive of the stated value and mean within an acceptable range of deviation for the particular value as determined by one of ordinary skill in the art, considering the measurement in question and the error associated with measurement of the particular quantity (e.g., the limitations of the measurement system).

Example embodiments may be described herein with reference to cross-sectional illustrations and/or plane illustrations that may be example illustrations. In the drawings, the thicknesses of layers and regions may be exaggerated for clarity. Accordingly, variations from the shapes of the illustrations as a result, for example, of manufacturing techniques and/or tolerances, are to be expected. Thus, example embodiments should not be construed as limited to the shapes of regions illustrated herein but are to include deviations in shapes that result, for example, from manufacturing. For example, an etching region illustrated as a rectangle will, typically, have rounded or curved features. Thus, the regions illustrated in the figures are schematic in nature and their shapes are not intended to illustrate the actual shape of a region of a device and are not intended to limit the scope of example embodiments.

Unless otherwise defined, all terms (including technical and scientific terms) used herein have the same meaning as commonly understood by one of ordinary skill in the art to which example embodiments of the inventive concept belong. It is to be further understood that terms, such as those defined in commonly-used dictionaries, should be interpreted as having a meaning that is consistent with their meaning in the context of the relevant art and will not be interpreted in an idealized or overly formal sense unless expressly so defined herein.

Herein, some example embodiments of the inventive concepts will be described in further detail with reference to the accompanying drawings.

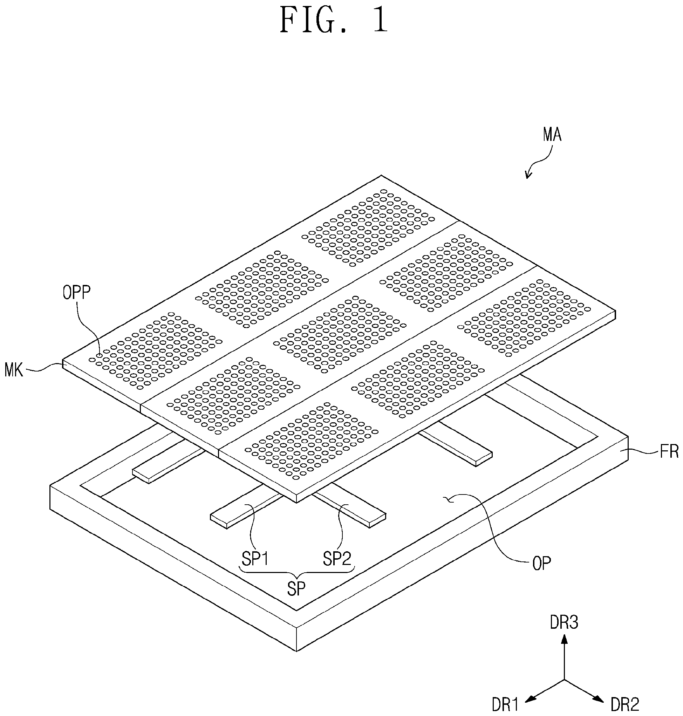

FIG. 1 is an exploded perspective view illustrating a mask assembly according to an embodiment of the inventive concepts.

Referring to FIG. 1, a mask assembly MA may be used in a process of depositing a deposition material. In an embodiment of the inventive concepts, the mask assembly MA includes a frame FR, a support portion SP, and a mask MK.

The frame FR may have a ring or loop shape when viewed in a plan view. In other words, an opening OP is provided in an area, such as an area including the center, of the frame FR. The opening OP may be a hole penetrating the frame FR from a top surface of the frame FR to a bottom surface of the frame FR.

A rectangular ring shape is illustrated as an example of the shape of the frame FR in FIG. 1. However, the shape of the frame FR is not limited thereto. In certain embodiments, the frame FR may have at least one of other various shapes, such as a circular ring shape and a polygonal ring shape.

The support portion SP is disposed on the frame FR. The support portion SP overlaps with at least a portion of the opening OP of the frame FR. The support portion SP may divide the opening OP into a plurality of areas.

In an embodiment, the support portion SP may be provided in plural, and the support portions SP will be described herein.

The support portions SP may include first support portions SP1 and second support portions SP2. Each of the first support portions SP1 may extend in a first direction DR1. The first support portions SP1 may be spaced apart from each other and be arranged in a second direction DR2 crossing the first direction DR1. Each of the second support portions SP2 may extend in the second direction DR2. The second support portions SP2 may be spaced apart from each other and be arranged in the first direction DR1. A distance between the first support portions SP1 and a distance between the second support portions SP2 may be adjusted depending on a size and a shape of an area in which the deposition material is to be deposited.

Two first support portions SP1 and two second support portions SP2 are illustrated as an example in FIG. 1. However, the number of each of the first and second support portions SP1 and SP2 is not limited thereto. In certain embodiments, the number of each of the first and second support portions SP1 and SP2 may be one or three or more.

In an embodiment, as shown in FIG. 1, a first width of each of the first support portions SP1 in the second direction DR2 is equal to a second width of each of the second support portions SP2 in the first direction DR1. However, embodiments of the inventive concepts are not limited thereto. In certain embodiments, the first width may be different from the second width. In an embodiment, for example, the first width of each of the first support portions SP1 having longer lengths may be greater than the second width.

The first support portions SP1 and the second support portions SP2 may be coupled to the frame FR. For example, the first support portions SP1 and the second support portions SP2 may be coupled to the frame FR by a welding method. However, embodiments of the inventive concepts are not limited thereto. In another embodiment, the first and second support portions SP1 and SP2 may be coupled to the frame FR by a coupling member (not shown), and the coupling member may include a material having an adhesive property. In still another embodiment, recesses (not shown) may be provided at a top surface of the frame FR. The recesses may be concave from the top surface of the frame FR, and the first and second support portions SP1 and SP2 may be inserted in the recesses. In other words, the first and second support portions SP1 and SP2 may be engaged with the frame FR.

The mask MK is disposed on the support portions SP. In an embodiment, the mask MK may be provided in plural, and the masks MK will be described herein.

The masks MK may be supported by the support portions SP. In an embodiment, the first support portions SP1 may support boundaries between the masks MK, and the second support portions SP2 may support partial areas of each of the masks MK.

In an embodiment, each of the masks MK may extend in the first direction DR1, and the masks MK may be arranged in the second direction DR2.

A plurality of opening patterns OPP may be defined in each of the masks MK. The plurality of opening patterns OPP may not overlap with the support portions SP and may overlap with the opening OP, when viewed in a plan view. The opening patterns OPP may be through-holes that penetrate the masks MK from top surfaces of the masks MK to bottom surfaces of the masks MK.

The masks MK may be coupled to the support portions SP. For example, the masks MK may be coupled to corresponding support portions SP by a welding method. However, embodiments of the inventive concepts are not limited thereto. In another embodiment, the masks MK may be coupled to the support portions SP by a coupling member (e.g., an adhesive).

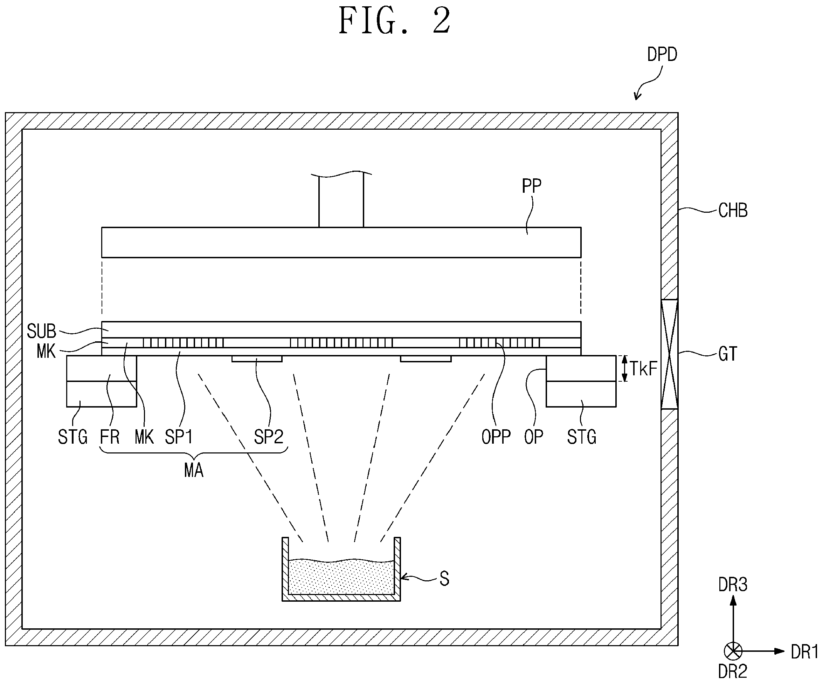

FIG. 2 is a cross-sectional view illustrating a deposition apparatus according to an embodiment of the inventive concepts.

Referring to FIG. 2, a deposition apparatus DPD may include a chamber CHB, a deposition source S, a stage STG, a movement plate PP, and the mask assembly MA.

The chamber CHB may provide an enclosed or sealed space. The deposition source S, the stage STG, the movement plate PP, and the mask assembly MA may be disposed in the chamber CHB. The chamber CHB may have at least one gate GT. The chamber CHB may be opened/closed by the gate GT. A target substrate SUB may enter and leave the chamber CHB through the gate GT of the chamber CHB.

The deposition source S may include a deposition material. The deposition material may include a material (e.g., at least one of an inorganic material, a metal, or an organic material) capable of being sublimated or evaporated. In an embodiment, the deposition source S may include an organic material for forming an organic light emitting element (not shown).

The stage STG may be disposed over the deposition source S. The mask assembly MA may be placed on the stage STG. The mask assembly MA may face the deposition source S. The stage STG may overlap with the frame FR of the mask assembly MA and may support the mask assembly MA. The stage STG may not overlap with the opening OP of the frame FR. In other words, the stage STG may be disposed outside a movement path of the deposition material supplied from the deposition source S to the target substrate SUB.

The target substrate SUB may be disposed on the mask assembly MA. The deposition material may be deposited to the target substrate SUB through the opening patterns OPP.

The movement plate PP may align the target substrate SUB on the mask assembly MA. For example, the movement plate PP may generate electrostatic force or magnetic force to move the target substrate SUB. The movement plate PP may be movable up and down or right and left.

In another embodiment, the movement plate PP may fix the target substrate SUB on the mask assembly MA. Since the target substrate SUB is fixed on the mask assembly MA by the movement plate PP, accuracy of a deposition process may be improved.

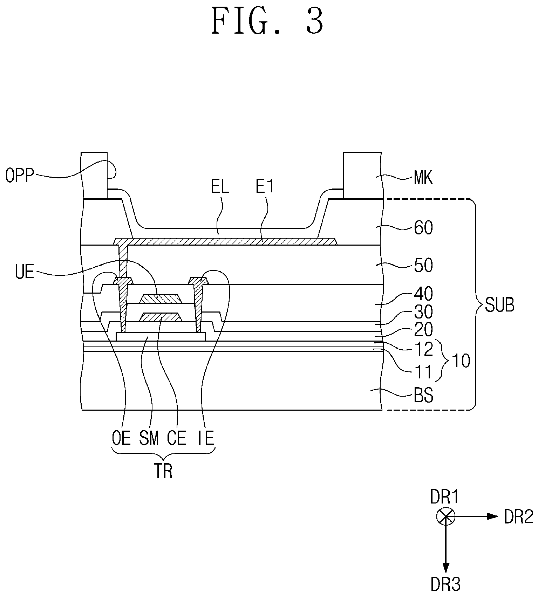

FIG. 3 is an enlarged cross-sectional view illustrating portions of the target substrate and the mask according to an embodiment of the inventive concepts.

Referring to FIG. 3, in an embodiment, the mask MK may be in contact with the target substrate SUB. The deposition material may be deposited on the target substrate SUB exposed by the opening pattern OPP of the mask MK.

In an embodiment, for example, the target substrate SUB may include a base layer BS, first to sixth insulating layers 10, 20, 30, 40, 50, and 60, a transistor TR, and a first electrode E1.

In an embodiment, the base layer BS may be a silicon substrate, a plastic substrate, a glass substrate, an insulating film, or a stack structure including a plurality of insulating layers.

The first insulating layer 10 may be disposed on the base layer BS. The first insulating layer 10 may include a barrier layer 11 and a buffer layer 12.

The barrier layer 11 may include an inorganic material. The barrier layer 11 may prevent or substantially prevent oxygen or moisture from permeating into pixels through the base layer BS. The buffer layer 12 may include an inorganic material. The buffer layer 12 may provide surface energy lower than that of the base layer BS to the pixels such that the pixels are stably formed on the base layer BS. In FIG. 3, each of the barrier layer 11 and the buffer layer 12 is illustrated as a single layer. However, embodiments of the inventive concepts are not limited thereto. In another embodiment, each of the barrier layer 11 and the buffer layer 12 may be provided in plural, and the barrier layers 11 and the buffer layers 12 may be alternately stacked. In other embodiments, at least one of the barrier layer 11 or the buffer layer 12 may be provided in plural or may be omitted.

Each of the pixels may include a pixel circuit and a light emitting element. The pixel circuit may include transistors TR and a capacitor. In FIG. 3, one transistor TR is illustrated as an example.

The transistor TR may be disposed on the first insulating layer 10. The transistor TR may include a semiconductor pattern SM, a control electrode CE, an input electrode IE, and an output electrode OE. The semiconductor pattern SM may be disposed on the first insulating layer 10. The semiconductor pattern SM may include a semiconductor material. The control electrode CE may be spaced apart from the semiconductor pattern SM with the second insulating layer 20 interposed therebetween.

The input electrode IE and the output electrode OE may be spaced apart from the control electrode CE with the third and fourth insulating layers 30 and 40 interposed therebetween. The input electrode IE and the output electrode OE may penetrate the second, third, and fourth insulating layers 20, 30, and 40 so as to be connected to one side portion and another side portion of the semiconductor pattern SM, respectively.

An upper electrode UE may be disposed between the third insulating layer 30 and the fourth insulating layer 40. The upper electrode UE may be connected to an electrode of a capacitor. Another electrode of the capacitor may be electrically connected to the control electrode CE.

The fifth insulating layer 50 may be disposed on the fourth insulating layer 40 to cover the input electrode IE and the output electrode OE.

The first electrode E1 may be disposed on the fifth insulating layer 50. The first electrode E1 may penetrate the fifth insulating layer 50 so as to be electrically connected to the transistor TR.

The sixth insulating layer 60 may be disposed on the fifth insulating layer 50. An opening may be defined in the sixth insulating layer 60, and the opening may expose at least a portion of the first electrode E1. The sixth insulating layer 60 may be a pixel defining layer.

The mask MK may be in contact with the sixth insulating layer 60. The opening pattern OPP of the mask MK may overlap with the opening of the sixth insulating layer 60 when viewed in a plan view. The deposition material may pass through the opening pattern OPP of the mask MK and then may be deposited on the first electrode E1. For example, an emission layer EL may be formed on the first electrode E1. The deposition material may be a material forming the emission layer EL. In other words, the emission layer EL may be the deposition material deposited on the target substrate SUB.

The emission layer EL may include a light emitting material. For example, the emission layer EL may include at least one of materials for emitting red light, green light, and blue light. The emission layer EL may include a fluorescent material or a phosphorescent material. The emission layer EL may include an organic light emitting material or an inorganic light emitting material.

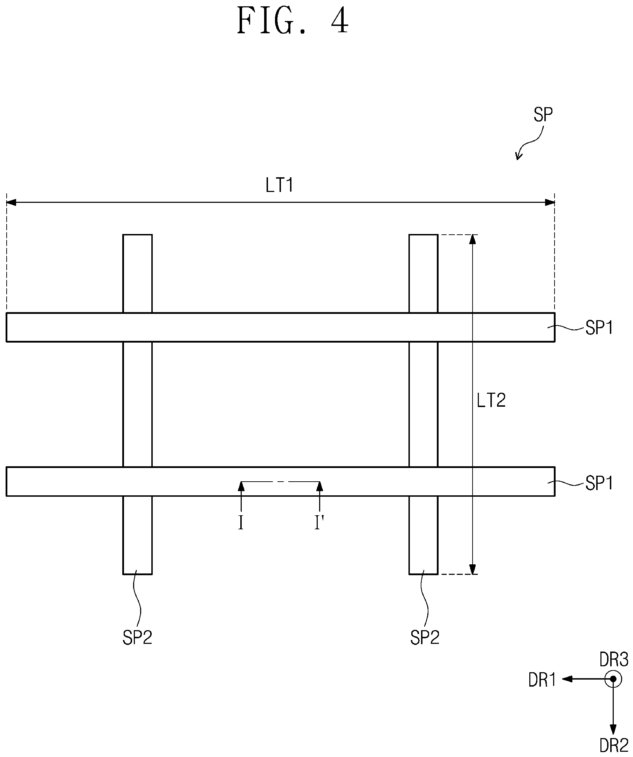

FIG. 4 is a plan view illustrating a support portion according to an embodiment of the inventive concepts.

Referring to FIG. 4, each of the first support portions SP1 may have a first length LT1 in the first direction DR1, and each of the second support portions SP2 may have a second length LT2 in the second direction DR2.

The first length LT1 and the second length LT2 may be changed depending on a change in temperature of the inside of the chamber CHB (see FIG. 2). If each of the first and second lengths LT1 and LT2 is increased by a certain length (e.g., a predetermined length) or more, each of the first and second support portions SP1 and SP2 may droop in the direction of gravity. This may cause deterioration of deposition reliability.

Referring again to FIG. 1, an appropriate range of a thermal expansion coefficient may be changed or selected depending on resolution of the opening patterns OPP of the mask MK, a size of the frame FR, a size or weight of the mask MK, the first length LT1, and/or the second length LT2.

According to an embodiment of the inventive concepts, the first and second support portions SP1 and SP2 having a certain range (e.g., a predetermined range) of a thermal expansion coefficient may be provided. Thus, it is possible to prevent or substantially prevent deposition reliability from being deteriorated by deformation of shapes of the first and second support portions SP1 and SP2. The thermal expansion coefficient may be measured using a Thermo Mechanical Analyzer (TMA). The thermal expansion coefficient may be measured based on the change in length of a sample that changes as it changes from room temperature to a specific temperature.

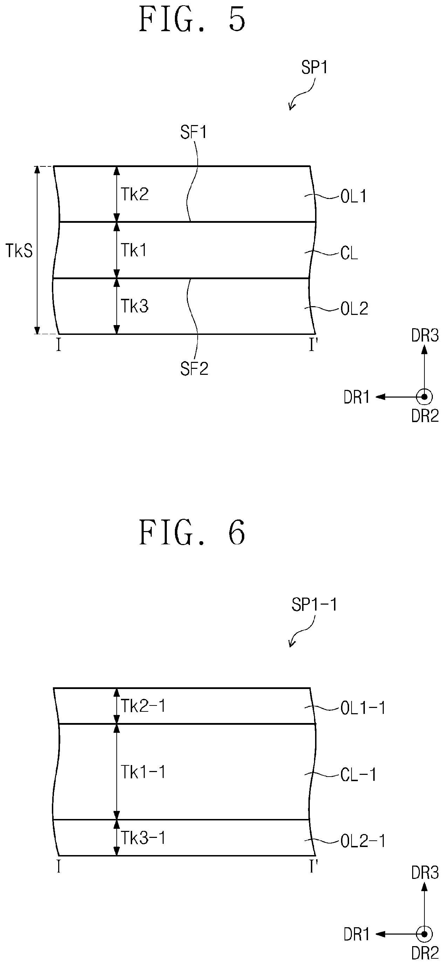

FIG. 5 is a cross-sectional view illustrating a support portion according to an embodiment of the inventive concepts. FIG. 5 may be a cross-sectional view taken along a line I-I' of FIG. 4.

Referring to FIG. 5, a support portion thickness TkS of the first support portion SP1 may be much less than a frame thickness TkF (see FIG. 2) of the frame FR (see FIG. 2). In an embodiment, for example, the frame thickness TkF (see FIG. 2) may be in a range from several centimeters to several tens of centimeters, and the support portion thickness TkS may be in a range from several micrometers to several hundreds of micrometers. For example, the support portion thickness TkS may be in a range from 10 micrometers to 200 micrometers. The first support portion SP1 may be more vulnerable to shape deformation by thermal expansion than the frame FR. According to an embodiment of the inventive concepts, the first support portion SP1 may be controlled to have the certain range (e.g., predetermined range) of a thermal expansion coefficient, and, thus, the shape deformation of the first support portion SP1 may be minimized or reduced. In an embodiment, the second support portion SP2 (see FIG. 2) may have substantially the same structure as the first support portion SP1, and, thus, further description of the second support portion SP2 will be omitted.

According to an embodiment of the inventive concepts, the first support portion SP1 may be a clad structure. The first support portion SP1 includes an odd number of base layers, for example, a central layer CL, a first outer layer OL1, and a second outer layer OL2.

The central layer CL is a layer disposed at a center of the first support portion SP1. The central layer CL includes a first surface SF1 and a second surface SF2. The first surface SF1 and the second surface SF2 are opposite to each other.

The first outer layer OL1 is disposed on the first surface SF1, and the second outer layer OL2 is disposed on the second surface SF2. In an embodiment, the first surface SF1 may be in direct contact with the first outer layer OL1, and the second surface SF2 may be in direct contact with the second outer layer OL2. In other words, other components may not be disposed between the central layer CL and the first outer layer OL1 and between the central layer CL and the second outer layer OL2. Thus, the first support portion SP1 may be a composite integrally formed by combination of the surfaces of the first outer layer OL1, the central layer CL, and the second outer layer OL2.

The central layer CL may include a different material from those of the first and second outer layers OL1 and OL2. In an embodiment, the first outer layer OL1 and the second outer layer OL2 may include the same material. For example, the first outer layer OL1 and the second outer layer OL2 may have the same thermal expansion coefficient, and the central layer CL may include a material having a thermal expansion coefficient different from the thermal expansion coefficient of the first and second outer layers OL1 and OL2.

Since the central layer CL, the first outer layer OL1, and the second outer layer OL2 constitute the first support portion SP1, a thermal expansion coefficient of the whole of the first support portion SP1 may be easily adjusted. For example, when the central layer CL includes a certain material (e.g., a predetermined material), the thermal expansion coefficient of the whole of the first support portion SP1 may be adjusted by changing the material of the first and second outer layers OL1 and OL2. On the other hand, when the first and second outer layers OL1 and OL2 include a certain material (e.g., a predetermined material), the thermal expansion coefficient of the whole of the first support portion SP1 may be adjusted by changing the material of the central layer CL.

In an embodiment, a first thickness Tk1 of the central layer CL, a second thickness Tk2 of the first outer layer OL1, and a third thickness Tk3 of the second outer layer OL2 may be equal (equal or substantially equal) to each other. In an embodiment, the thermal expansion coefficient of the first support portion SP1 may be adjusted by adjusting each of the first, second, and third thicknesses Tk1, Tk2, and Tk3.

For example, the first thickness Tk1 may have a thickness of 10 percent to 90 percent of the support thickness TkS. Each of the second thickness Tk2 and the third thickness Tk3 may have a ratio with respect to the support thickness TkS based on the first thickness TK1. For example, each of the second thickness Tk2 and the third thickness TK3 may have a thickness of 5 percent to 45 percent of the support thickness TkS.

In an embodiment, the second thickness Tk2 and the third thickness Tk3 may be equal (equal or substantially equal) to each other. For example, even though the first outer layer OL1 and the second outer layer OL2 may include the same material, the amount of change in length of the first outer layer OL1 by temperature may be different from the amount of change in length of the second outer layer OL2 by temperature if the second thickness Tk2 is different from the third thickness Tk3. In this case, the first support portion SP1 may be warped in a direction. However, when the second thickness Tk2 is substantially equal to the third thickness Tk3, the amount of change in length of the first outer layer OL1 by temperature may be substantially equal to the amount of change in length of the second outer layer OL2 by temperature. Thus, it is possible to prevent or substantially prevent the phenomenon that the first support portion SP1 is warped in a specific direction.

In an embodiment, the first support portion SP1 may have a symmetrical structure with respect to the central layer CL. For example, the second thickness Tk2 of the first outer layer OL1 and the third thickness Tk3 of the second outer layer OL2 may be equal (equal or substantially equal) to each other with respect to the central layer CL. In addition, the thermal expansion coefficient of the first outer layer OL1 and the thermal expansion coefficient of the second outer layer OL2 may be equal to each other with respect to the central layer CL.

In an embodiment, a magnetic force of the central layer CL may be greater than a magnetic force of the first and second outer layers OL1 and OL2. In an embodiment, the magnetic force of each of the first and second outer layers OL1 and OL2 may be close to zero. For example, the first outer layer OL1 and the second outer layer OL2 may include a non-magnetic material. Since the outer layers of the first support portion SP1 may be formed of the non-magnetic material, it is possible to minimize or reduce the influence of electrostatic force or magnetic force generated in a process on the first support portion SP1. The magnetic force may be measured through Magnetic Property Measurement System (MPMS) or Physical Property Measurement System (PPMS). The magnetic force may be assessed through a B-H curve or a M-H Curve.

In an embodiment, the central layer CL may include Invar, and each of the first and second outer layers OL1 and OL2 may include stainless steel. The stainless steel may be SUS301, SUS304, or SUS316. However, the materials of the central layer CL and the first and second outer layers OL1 and OL2 are not limited to the above examples. In another embodiment, the central layer CL may include stainless steel, and each of the first and second outer layers OL1 and OL2 may include Invar.

The central layer CL and the first outer layer OL1 may be metal-bonded to each other, and the central layer CL and the second outer layer OL2 may be metal-bonded to each other. The metal bond may mean that an alloy is formed at a bonding interface between the central layer CL and the first outer layer OL1 and a bonding interface between the central layer CL and the second outer layer OL2.

FIG. 6 is a cross-sectional view illustrating a support portion according to an embodiment of the inventive concepts.

Referring to FIG. 6, a cross-section of a first support portion SP1-1 is illustrated as an example. In an embodiment, the first support portion SP1-1 may be a clad structure. The first support portion SP1-1 may include a central layer CL-1, a first outer layer OL1-1, and a second outer layer OL2-1.

The first support portion SP1-1 may have a symmetrical structure with respect to the central layer CL-1 and a symmetrical thermal expansion coefficient with respect to the central layer CL-1.

A first thickness Tk1-1 of the central layer CL-1 may be different from a second thickness Tk2-1 of the first outer layer OL1-1 and a third thickness Tk3-1 of the second outer layer OL2-1. The second thickness Tk2-1 may be equal (equal or substantially equal) to the third thickness Tk3-1.

In an embodiment, as shown in FIG. 6, the first thickness Tk1-1 is greater than the second thickness Tk2-1 and the third thickness Tk3-1. However, embodiments of the inventive concepts are not limited thereto. In another embodiment, the second thickness Tk2-1 and the third thickness Tk3-1 may be greater than the first thickness Tk1-1.

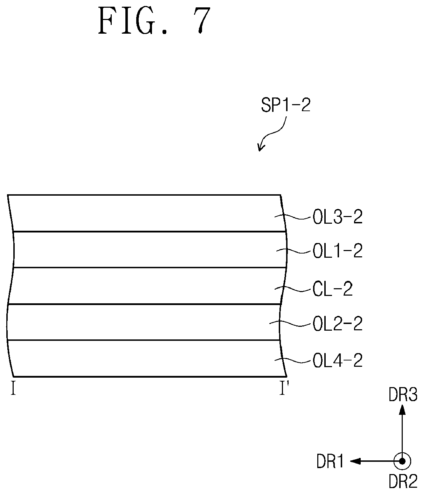

FIG. 7 is a cross-sectional view illustrating a support portion according to an embodiment of the inventive concepts.

Referring to FIG. 7, a cross-section of a first support portion SP1-2 is illustrated as an example.

In an embodiment, the first support portion SP1-2 may be a clad structure. The first support portion SP1-2 may include a central layer CL-2, a first outer layer OL1-2, a second outer layer OL2-2, a third outer layer OL3-2, and a fourth outer layer OL4-2. The first support portion SP1-2 may have a symmetrical structure with respect to the central layer CL-2 and a symmetrical thermal expansion coefficient with respect to the central layer CL-2.

In an embodiment, the first support portion may include 2n+1 base layers, where n is a natural number of 1 or more. For example, each of the first support portions SP1 and SP1-1 described with reference to FIGS. 5 and 6 includes three base layers. The first support portion SP1-2 including five base layers is illustrated as an example in FIG. 7.

The first support portion was described through FIGS. 5 to 7. However, the second support portion SP2 illustrated in FIG. 4 may also include 2n+1 base layers, where n is a natural number of 1 or more, like the first support portion. In addition, the second support portion SP2 may also be a clad structure.

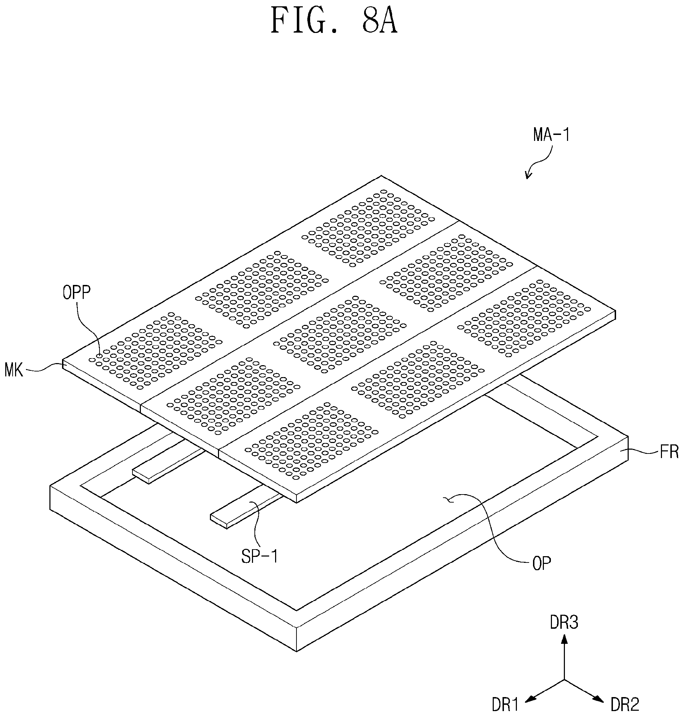

FIG. 8A is an exploded perspective view illustrating a mask assembly according to an embodiment of the inventive concepts.

Referring to FIG. 8A, a mask assembly MA-1 may include the frame FR, support portions SP-1, and the masks MK. In an embodiment, each of the support portions SP-1 may be a clad structure and may include 2n+1 base layers, where n is a natural number of 1 or more.

The masks MK may extend in the first direction DR1 and may be arranged in the second direction DR2. The support portions SP-1 may extend in the first direction DR1 and may be arranged in the second direction DR2.

One of the support portions SP-1 may overlap with two adjacent masks MK. In other words, one support portion may support two masks.

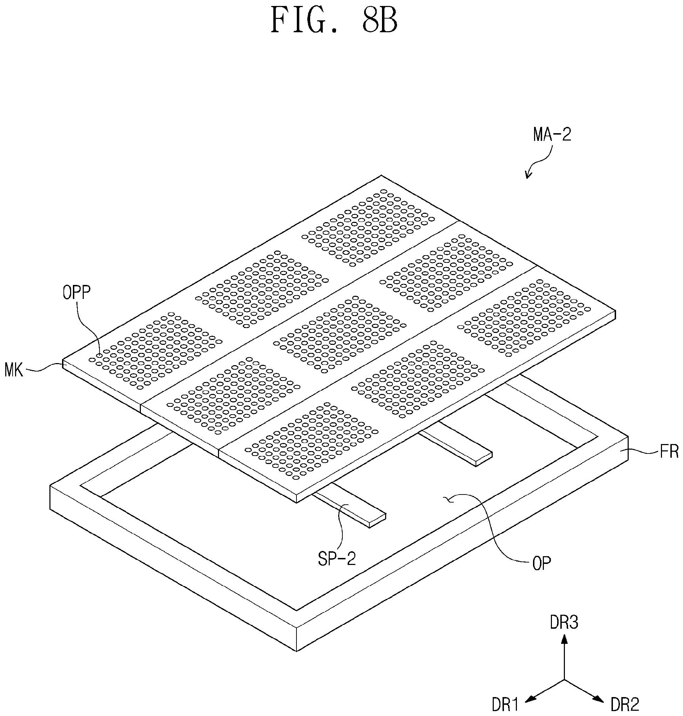

FIG. 8B is an exploded perspective view illustrating a mask assembly according to an embodiment of the inventive concepts.

Referring to FIG. 8B, a mask assembly MA-2 may include the frame FR, support portions SP-2, and the masks MK. In an embodiment, each of the support portions SP-2 may be a clad structure and may include 2n+1 base layers, where n is a natural number of 1 or more.

The masks MK may extend in the first direction DR1 and may be arranged in the second direction DR2. The support portions SP-2 may extend in the second direction DR2 and may be arranged in the first direction DR1. The extending direction of each of the support portions SP-2 may cross the extending direction of each of the masks MK. In an embodiment, each of the support portions SP-2 may support all of the masks MK.

The support portions SP-2 may not overlap with an effective area of the mask MK when viewed in a plan view. The effective area may mean an area through which the deposition material passes. In FIG. 8B, an area in which the opening patterns OPP are provided may be defined as the effective area. Thus, the support portions SP-2 may not overlap with the opening patterns OPP when viewed in a plan view.

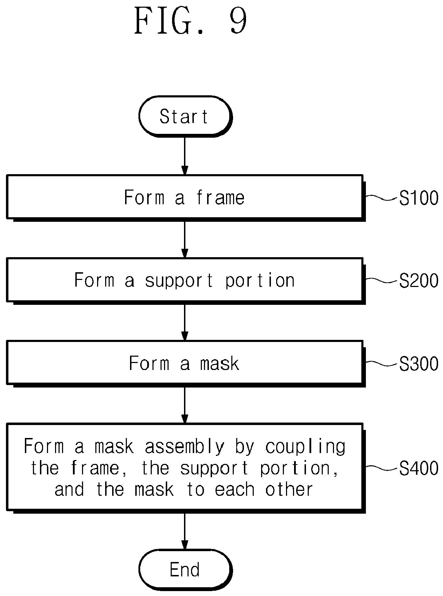

FIG. 9 is a flowchart illustrating a method of manufacturing a mask assembly, according to an embodiment of the inventive concepts.

Referring to FIGS. 1 and 9, the frame FR may be formed or provided (S100). The opening OP may be defined in the frame FR. In an embodiment, the frame FR may include Invar. In an embodiment, each of the frame FR and the mask MK may include Invar.

The support portion SP may be formed (S200). The support portion SP may be disposed on the frame FR. The support portion SP may be disposed on the frame FR to overlap with the opening OP. In an embodiment, the support portion SP may include at least two or more materials.

The mask MK may be formed or provided (S300). The opening patterns OPP may be defined in the mask MK. The mask MK may be disposed on the support portion SP. The opening patterns OPP may not overlap with the support portion SP and may overlap with the opening OP, when viewed in a plan view.

The mask assembly MA may be formed by coupling the frame FR, the support portion SP, and the mask MK to each other (S400).

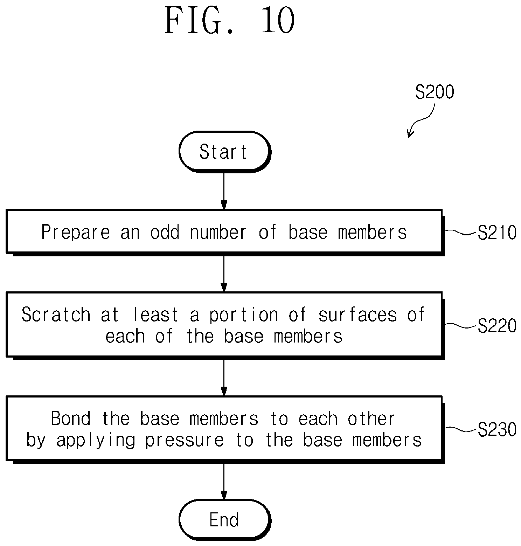

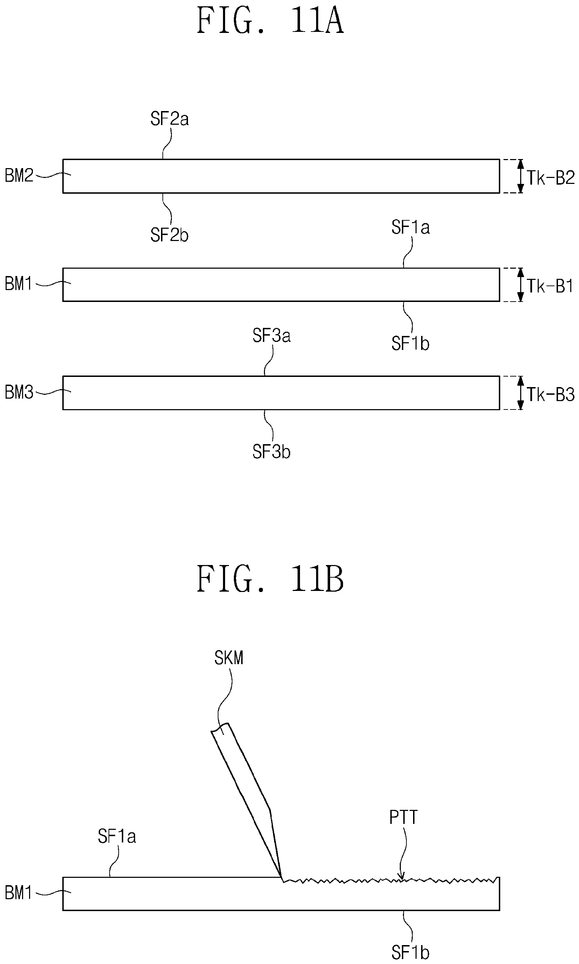

FIG. 10 is a flowchart illustrating a method of manufacturing a support portion, according to an embodiment of the inventive concepts. FIGS. 11A to 11D are cross-sectional views schematically illustrating some processes of a method of manufacturing a support portion, according to an embodiment of the inventive concepts.

Referring to FIGS. 10 and 11A, an odd number of base members BM1, BM2, and BM3 may be prepared (S210). In FIG. 11A, three base members BM1, BM2, and BM3 are illustrated as an example. The three base members BM1, BM2, and BM3 may include a first base member BM1, a second base member BM2, and a third base member BM3.

The first base member BM1 may include a first surface SF1a and a second surface SF1b, the second base member BM2 may include a first surface SF2a and a second surface SF2b, and the third base member BM3 may include a first surface SF3a and a second surface SF3b. The second base member BM2, the first base member BM1, and the third base member BM3 may be sequentially arranged in one direction. The first surface SF1a may face the second surface SF2b, and the second surface SF1b may face the first surface SF3a.

The first base member BM1 may have a first thickness Tk-B1, the second base member BM2 may have a second thickness Tk-B2, and the third base member BM3 may have a third thickness Tk-B3. In an embodiment, the second thickness Tk-B2 and the third thickness Tk-B3 may be equal to each other. A ratio of each of the second and third thicknesses Tk-B2 and Tk-B3 to the first thickness Tk-B1 may be variously adjusted. For example, the ratio may be adjusted depending on a set range of a thermal expansion coefficient such that a thermal expansion coefficient is in the set range of the thermal expansion coefficient.

Referring to FIGS. 10 and 11B, at least a portion of the surface(s), facing other base member(s), of the surfaces of each of the three base members BM1, BM2, and BM3 may be scratched (S220). For example, at least a portion of the first surface SF1a, the second surface SF1b, the second surface SF2b, and the first surface SF3a may be scratched. For example, the first surface SF1a may be scratched using a scratch member SKM. A rough surface PTT may be formed in an area of the first surface SF1a where the scratch member SKM passes. The three base members BM1, BM2, and BM3 may be easily bonded or coupled to each other by the rough surface PTT.

In some embodiments, all of the first surface SF1a, the second surface SF1b, the second surface SF2b, and the first surface SF3a may be scratched using the scratch member SKM, or one or some of the first surface SF1a, the second surface SF1b, the second surface SF2b, and the first surface SF3a may be scratched using the scratch member SKM. In another embodiment, the process of scratching the first surface SF1a, the second surface SF1b, the second surface SF2b, and the first surface SF3a by using the scratch member SKM may be omitted.

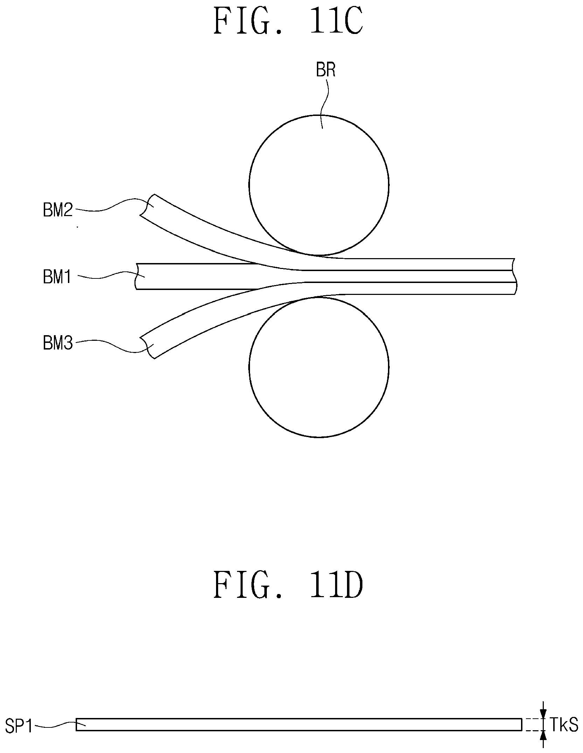

Referring to FIGS. 10 and 11C, in an embodiment, the three base members BM1, BM2, and BM3 may be provided between bonding rollers BR. The bonding rollers BR may apply pressure to the three base members BM1, BM2, and BM3 to bond the three base members BM1, BM2, and BM3 to each other (S230).

In an embodiment, the process of bonding the base members BM1, BM2, and BM3 by using the bonding rollers BR may be repeated a plurality of times. Referring to FIG. 11D, the first support portion SP1 having a support portion thickness TkS may be formed.

In an embodiment, heat may be applied to the bonding rollers BR. For example, the bonding rollers BR may apply heat and pressure to the base members BM1, BM2, and BM3. In an embodiment, an environment of pressing the base members BM1, BM2, and BM3 by using the bonding rollers BR may have a predetermined temperature range. In this case, the base members BM1, BM2, and BM3 may be bonded to each other in the environment having the predetermined temperature range. In other words, the process of applying pressure to the base members BM1, BM2, and BM3 while applying heat may be referred to as a hot rolling process.

The process of forming the first support portion SP1 using the base members BM1, BM2, and BM3 may further include a cold rolling process. The cold rolling process may be a process of applying pressure to the base members BM1, BM2, and BM3 at room temperature.

In some embodiments, the process of forming the first support portion SP1 may include both the cold rolling process and the hot rolling process or may include only the cold rolling process or only the hot rolling process.

According to embodiments of the inventive concepts, the mask assembly includes the support portion supporting the mask. The support portion includes a plurality of the base layers. The thermal expansion coefficient of the support portion may be adjusted by changing or selecting the material and/or the thickness of each of the base layers. Thus, the thermal expansion coefficient of the support portion may be set in a range capable of minimizing or reducing the shape deformation of the support portion. As a result, the deposition reliability may be improved.

While the inventive concepts have been described with reference to some example embodiments, it will be apparent to those skilled in the art that various changes and modifications may be made without departing from the scope of the inventive concepts. Therefore, it should be understood that the above described embodiments are not limiting, but illustrative. Thus, the scope of the inventive concepts is to be determined by the broadest permissible interpretation of the claims and their equivalents, and shall not be restricted or limited by the foregoing description.

## Claims

1. A mask assembly (MA) comprising:
a frame (FR) in which an opening (OP) is defined;
a support portion (SP) on the frame (FR) and overlapping with the opening (OP); and
a mask (MK) on the support portion (SP) and covering at least a portion of the opening (OP),
wherein the support portion (SP) comprises:
a central layer (CL);
a first outer layer (OL1) on a first surface (SF1) of the central layer (CL); and
a second outer layer (OL2) on a second surface (SF2) of the central layer (CL), the second surface (SF2) being opposite to the first surface (SF1).

2. A mask assembly (MA) according to claim 1, wherein the first surface (SF1) is in direct contact with the first outer layer (OL1), and the second surface (SF2) is in direct contact with the second outer layer (OL2).

3. A mask assembly (MA) according to claim 1 or claim 2, wherein the central layer (CL) is metal-bonded to the first outer layer (OL1), and the central layer (CL) is metal-bonded to the second outer layer (OL2).

4. A mask assembly (MA) according to any one of claims 1 to 3, wherein the central layer (CL) comprises a different material from the first and second outer layers (OL1, OL2), and the first and second outer layers (OL1, OL2) comprise the same material.

5. A mask assembly (MA) according to any one of claims 1 to 4, wherein a thermal expansion coefficient of the central layer (CL) is different from a thermal expansion coefficient of the first outer layer (OL1).

6. A mask assembly (MA) according to any one of claims 1 to 5, wherein a magnetic force of the central layer (CL) is greater than a magnetic force of each of the first and second outer layers (OL1, OL2).

7. A mask assembly (MA) according to any one of claims 1 to 6, wherein the central layer (CL) comprises Invar, and each of the first and second outer layers (OL1, OL2) comprises stainless steel.

8. A mask assembly (MA) according to any one of claims 1 to 7, wherein the support portion (SP) is provided in plural, and the plural support portions (SP1) extend in a first direction (DR1) and are arranged in a second direction (DR2) crossing the first direction (DR1).

9. A mask assembly (MA) according to any one of claims 1 to 8, wherein the support portion (SP) is provided in plural; some of the plural support portions (SP1) extend in a first direction (DR1) and are arranged in a second direction (DR2) crossing the first direction (DR1); and others of the plural support portions (SP2) extend in the second direction (DR2) and are arranged in the first direction (DR1).

10. A mask assembly (MA) according to claim 9, wherein the mask (MK) is provided in plural, the plural masks (MK) extend in the first direction (DR1) and are arranged in the second direction (DR2); and a plurality of opening patterns (OPP) is defined in each of the masks (MK).

11. A mask assembly (MA) according to any one of claims 1 to 10, wherein each of the frame (FR) and the mask (MK) comprises Invar.

12. A mask assembly (MA) according to any one of claims 1 to 11, wherein the support portion (SP) has a symmetrical structure with respect to the central layer (CL).

13. A mask assembly (MA) according to claim 12, wherein the first outer layer (OL1) and the second outer layer (OL2) have the same thickness.

14. A mask assembly (MA) according to claim 12 or claim 13, wherein the first outer layer (OL1) and the second outer layer (OL2) have the same thermal expansion coefficient.
